Europäisches Patentamt

European Patent Office

Office européen des brevets

(19)

(11) Veröffentlichungsnummer: **0 387 483**
**A1**

## (12) EUROPÄISCHE PATENTANMELDUNG

(21) Anmeldenummer: **90100289.9**

(22) Anmeldetag: **08.01.90**

(51) Int. Cl.5: **H01L 31/101, H01L 31/103, H01L 31/11**

(30) Priorität: **16.03.89 CH 981/89**

(43) Veröffentlichungstag der Anmeldung:
**19.09.90 Patentblatt 90/38**

(84) Benannte Vertragsstaaten:
**CH DE DK FR GB IT LI NL**

(71) Anmelder: **Landis & Gyr Betriebs AG**

**CH-6301 Zug(CH)**

(72) Erfinder: **Popovic, Radivoje**
**Fridbach 1**
**CH-6300 Zug(CH)**
Erfinder: **Stössel, Zeno**
**Schutzengelstrasse 34C**
**CH-6340 Baar(CH)**

(54) **Ultraviolettlicht-Photodiode.**

(57) Die Ultraviolettlicht-Photodiode besteht aus der Kombination zweier Photodioden, die elektrisch so miteinander verbunden sind, dass bei Belichtung der beiden Photodioden ein Signal entsteht, welches proportional der Differenz beider Diodenströme ist. Die Maxima der spektralen Empfindlichkeitskurven (1, 2) der beiden Photodioden weisen unterschiedliche Wellenlängen auf. Die spektralen Empfindlichkeitskurven (1, 2) der beiden Photodioden besitzen im Bereich der Wellenlängen des sichtbaren Lichtes und des Infrarotlichtes annähernd gleiche Werte, so dass in diesem Bereich sich die Diodenströme beider Photodioden annähernd durch Differenzbildung kompensieren. Eine erste der beiden Photodioden ist im Bereich der Wellenlängen des ultravioletten Lichtes empfindlicher als die zweite Photodiode, so dass die Empfindlichkeitskurve (3) der Ultraviolettlicht-Photodiode schmalbandig im Bereich der Wellenlängen des ultravioletten Lichtes ein Maximum aufweist. Die Ultraviolettlicht-Photodiode wird vorteilhaft zur Flammenüberwachung in Verbrennungsanlagen verwendet.

Fig. 1

EP 0 387 483 A1

Die Erfindung bezieht sich auf eine Ultraviolettlicht-Photodiode gemäss dem Oberbegriff des Anspruchs 1.

Solche Ultraviolettlicht-Photodioden sind aus der EP 0 296 371 A1 bekannt. Die bekannten Ultraviolettlicht-Photodioden sind in der Regel breitbandig und besitzen daher eine relativ schlechte spektrale Selektivität.

Farb-Sensoren, die aus der Kombination zweier Photodioden mit unterschiedlichen Spektralempfindlichkeiten bestehen, sind zur Flammenüberwachung aus der Druckschrift "Sensors and Actuators, 4 (1983), pages 655 bis 660, Combustion detection with a semiconductor color sensor, N. Kako et al" bekannt.

Der Erfindung liegt die Aufgabe zugrunde, hocheffiziente Ultraviolettlicht-Photodioden zu realisieren, die eine spektrale Selektivität besitzen, die mindestens eine Grössenordnung besser ist als diejenige der bekannten Ultraviolettlicht-Photodioden.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen, wobei bei einer Ausgestaltung die spektrale Empfindlichkeit unabhängig ist von der Temperatur und von Variationen der Herstellungsprozesse.

Derartige Ultraviolettlicht-Photodioden werden vorteilhaft zur Flammenüberwachung in Kontrollausrüstungen von Verbrennungsanlagen, z. B. in Flammenwächtern von Heizungsanlagen, sowie in Ultraviolettlicht-Messgeräten oder Ultraviolettlicht-Dosismetern für industrielle und medizinische Anwendungen verwendet.

Ausführungsbeispiele der Erfindung sind in der Zeichnung dargestellt und werden im folgenden näher beschrieben.

Es zeigen:

Fig. 1 spektrale Empfindlichkeitskurven von drei verschiedenen Arten von Photodioden,

Fig. 2 eine erste Variante der Beschaltung einer kompensierten Ultraviolettlicht-Photodiode,

Fig. 3 eine zweite Variante der Beschaltung einer kompensierten Ultraviolettlicht-Photodiode,

Fig. 4 einen Querschnitt einer ersten Variante eines integrierten Halbleiteraufbaus der in der Fig. 3 dargestellten kompensierten Ultraviolettlicht-Photodiode,

Fig. 5 einen Querschnitt einer zweiten Variante des integrierten Halbleiteraufbaus der in der Fig. 3 dargestellten kompensierten Ultraviolettlicht-Photodiode,

Fig. 6 Dotierungsprofile verschiedener Halbleiterschichten der in der Fig. 5 dargestellten kompensierten Ultraviolettlicht-Photodiode,

Fig. 7 Potentialverteilungen innerhalb der Halbleiterschichten einer kompensierten Ultraviolettlicht-Photodiode,

Fig. 8 eine erste Variante der Draufsicht einer kompensierten Ultraviolettlicht-Photodiode, die zur Messung von nichtuniformem Licht geeignet ist,

Fig. 9 eine zweite Variante der Draufsicht einer kompensierten Ultraviolettlicht-Photodiode, die zur Messung von nichtuniformem Licht geeignet ist, und

Fig.10 eine dritte Variante der Draufsicht einer kompensierten Ultraviolettlicht-Photodiode, die zur Messung von nichtuniformem Licht geeignet ist.

Gleiche Bezugszahlen bezeichnen in allen Figuren der Zeichnung gleiche Teile.

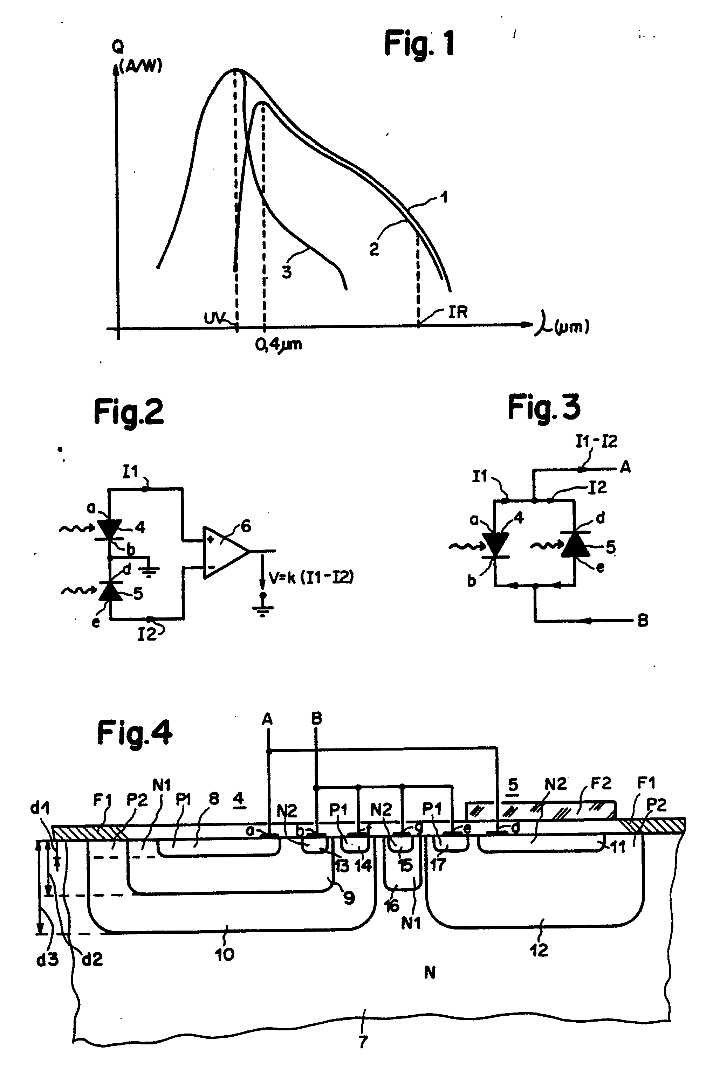

In der Fig. 1 sind spektrale Empfindlichkeitskurven 1, 2 und 3 von drei Photodioden 4, 5 und 4;5 dargestellt, wobei jeweils entlang der Abszisse die Wellenlänge Lamda des sichtbaren und unsichtbaren Lichtes und entlang der Ordinate die spektrale Empfindlichkeit Q aufgetragen ist. Die spektrale Empfindlichkeit Q wird z. B. in Ampere/Watt und die Wellenlänge Lamda in μm gemessen.

Die Empfindlichkeitskurve 1 ist diejenige einer ersten Photodiode 4 und besitzt ein Maximum im Bereich der Wellenlängen des ultravioletten Lichtes UV, während die Empfindlichkeitskurve 2 diejenige einer zweiten Photodiode 5 ist, deren Maximum bei einer Wellenlänge in der Grössenordnung von 0,4 μm liegt. Die Maxima der spektralen Empfindlichkeitskurven 1 und 2 der beiden Photodioden 4 und 5 weisen somit unterschiedliche Wellenlängen auf. Die spektralen Empfindlichkeitskurven 1 und 2 besitzen ausserdem im Bereich der Wellenlängen des sichtbaren Lichtes und des Infrarotlichtes annähernd gleiche Werte, so dass sich in diesem Bereich die Diodenströme der beiden Photodioden 4 und 5 bei einer Differenzbildung der beiden Diodenströme annähernd kompensieren. Die erste Photodiode 4 ist im Bereich der Wellenlängen des ultravioletten Lichtes viel empfindlicher als die zweite Photodiode 5, so dass die durch Differenzbildung der beiden Empfindlichkeitskurven 1 und 2 entstehende Empfindlichkeits kurve 3 schmalbandig im Bereich der Wellenlängen des ultravioletten Lichtes UV ein Maximum aufweist. Die Empfindlichkeitskurve 3 ist diejenige einer erfindungsgemässen kompensierten Ultraviolettlicht-Photodiode 4;5, die durch eine Kombination der beiden Photodioden 4 und 5 gebildet ist, welche beide elektrisch so miteinander verbunden sind, dass bei Belichtung der beiden Photodioden 4 und 5 ein Signal entsteht, welches proportional der Differenz der Diodenströme der beiden Photodioden 4 und 5 ist.

In den Figuren 2 bis 5 ist bei der ersten Photodiode 4 jeweils der Kontaktanschluss der Anode mit a und derjenige der Kathode mit b bezeichnet, während bei der zweiten Photodiode 5 der Kontaktanschluss der Kathode mit d und derjenige der Anode mit e bezeichnet ist.

In der Fig. 2 ist eine erste Variante der kompensierten Ultraviolettlicht-Photodiode dargestellt, in der die beiden Photodioden 4 und 5 in Gegenrichtung elektrisch in Reihe geschaltet sind, wobei ihr gemeinsamer Pol, der z. B. durch die Anschlusskontakte b und d der beiden Kathoden gebildet ist, vorzugsweise an Masse liegt. Die Anschlusskontakte a und e der Anoden der beiden Photodioden 4 und 5 bilden so die Anschlusskontakte einer Reihenschaltung und sind mit je einem von zwei Eingängen eines Differenzverstärkers 6 verbunden, der einen relativ niederohmigen Differenz-Eingangswiderstand aufweist. Die beiden Photodioden 4 und 5 arbeiten unter dem Einfluss von sichtbarem und unsichtbarem Licht als Stromquellen und liefern je einen Diodenstrom I1 bzw. I2. Die Ausgangsspannung V des Differenzverstärkers 6 ist dann gleich k.[I1-I2], wobei k eine Proportionalitätskonstante darstellt.

In der Fig. 3 ist eine zweite Variante der kompensierten Ultraviolettlicht-Photodiode dargestellt, in der die beiden Photodioden 4 und 5 in Gegenrichtung elektrisch parallel geschaltet sind, also der Anschlusskontakt b bzw. d der Kathode der einen Photodiode 4 bzw. 5 mit dem Anschlusskontakt e bzw. a der Anode der andern Photodiode 5 bzw. 4 verbunden ist. Auch hier erzeugen die beiden Photodioden 4 und 5 je einen Diodenstrom I1 bzw. I2, wobei die Parallelschaltung der beiden Photodioden 4 und 5 bei Belichtung eine Stromquelle darstellt, die einen Differenzstrom I1-I2 erzeugt, der an den Klemmen A und B der Parallelschaltung der Photodioden 4 und 5 erscheint.

In den beiden in der Fig. 2 bzw. Fig. 3 dargestellten Schaltungen sind somit die beiden Photodioden 4 und 5 elektrisch so miteinander verbunden, dass bei Belichtung der beiden Photodioden 4 und 5 jeweils ein Ausgangssignal entsteht, welches proportional der Differenz I1-I2 der beiden Diodenströme I1 und I2 ist. Da die beiden Diodenströme I1 und I2 im Bereich des sichtbaren Lichtes und des Infrarotlichtes annähernd gleich gross sind, eliminieren und kompensieren sich deren Spektralkomponenten durch die Differenzbildung der beiden Diodenströme I1 und I2. Es bleiben praktisch nur mehr die Spektralkomponenten des ultravioletten Lichtes der Photodiode 4 übrig, da diejenigen der Photodiode 5 praktisch gegenüber derjenigen der Photodiode 4 vernachlässigbar klein sind. Die Kombination der beiden Photodioden 4 und 5 besitzt dann die spektrale Empfindlichkeitskurve 3, die sehr viel schmalbandiger ist als die Kennlinie 1 der nichtkompensierten Photodiode 4.

Die beiden Photodioden 4 und 5 bestehen aus Halbleitermaterial und können sowohl in einem gleichen Substrat 7 integriert als auch diskret mit getrennten Substraten aufgebaut sein. Im letzten Fall sind sie ausserhalb des jeweiligen Halbleitermaterials elektrisch miteinander verbunden. Das Halbleitermaterial kann in allen Fällen Silizium oder GaAs sein. Die nachfolgend erwähnten Schichten 8 bis 12 inklusive 11a und 11b bestehen jeweils aus Halbleitermaterial und sind in der Regel wannenförmig. Das Halbleitermaterial ist entweder vom Leitfähigkeitstyp N und ist dann mit N, N1, N1R oder N2 bezeichnet oder vom entgegengesetzten Leitfähigkeitstyp P und ist dann mit P1, P1R oder P2 bezeichnet.

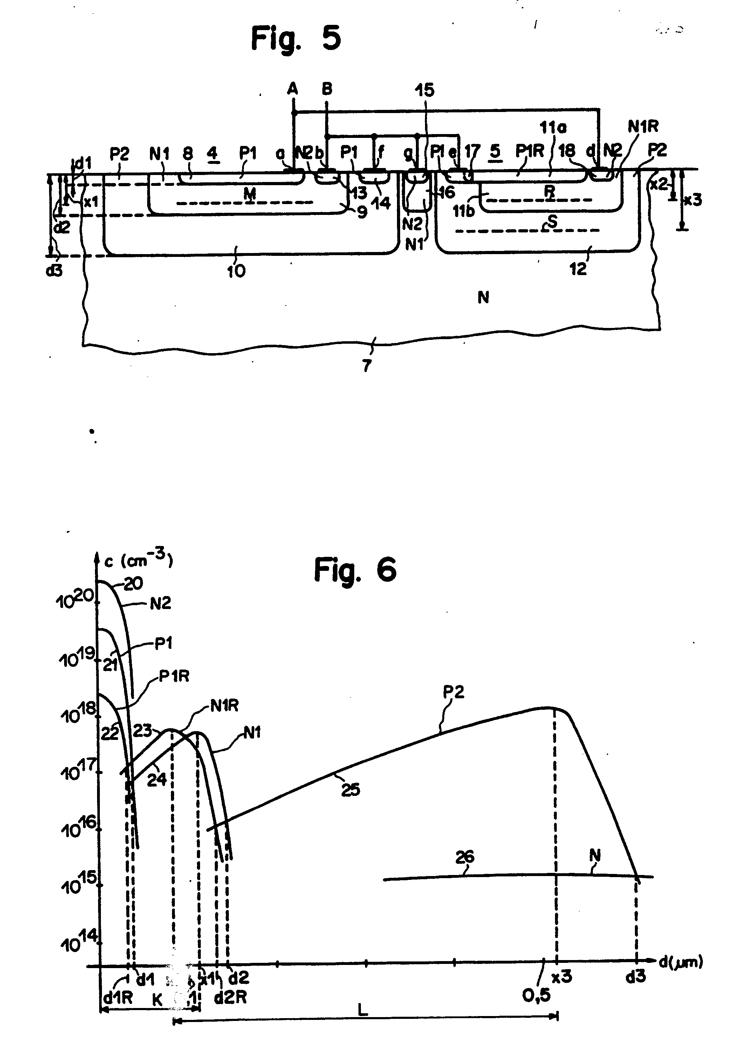

Nachfolgend wird angenommen, dass die Kombination der beiden Photodioden 4 und 5 als integrierte Schaltung ausgebildet ist und die beiden Photodioden 4 und 5 im gleichen Substrat 7 integriert sind. In der Fig. 4 und der Fig. 5 ist die erste Photodiode 4 jeweils links und die zweite Photodiode 5 rechts in der Zeichnung dargestellt, wobei die beiden Photodioden 4 und 5 jeweils wie in der Fig. 3 dargestellt elektrisch miteinander verbunden sind.

Die kompensierte Ultraviolettlicht-Photodiode 4;5 besteht in den beiden in der Fig. 4 und der Fig. 5 dargestellten Varianten jeweils aus dem Substrat 7, aus fünf Schichten 8 bis 12 bzw. sechs Schichten 8, 9, 10, 11a, 11b und 12 sowie aus fünf bzw. sechs Kontaktdiffusionen 13 bis 17 bzw. 13 bis 18.

Der Aufbau der ersten Photodiode 4 ist in beiden Varianten gleich. Die Photodiode 4 besteht jeweils aus der ersten Schicht 8, die an der Oberfläche in der zweiten Schicht 9 angeordnet ist, die sich ihrerseits an der Oberfläche in der dritten Schicht 10 befindet, welche wiederum an der Oberfläche im Substrat 7 angeordnet ist. Die Schichten 8 und 10 einerseits bestehen aus Halbleitermaterial vom gleichen Leitfähigkeitstyp P1 bzw. P2 und die Schicht 9 sowie das Substrat 7 anderseits aus Halbleitermaterial vom gleichen jedoch entgegengesetzten Leitfähigkeitstyp N1 bzw. N. Die drei Schichten 8 bis 10 weisen an ihren Oberflächen je einen metallischen Anschlusskontakt a bzw. b bzw. f auf, wobei diejenigen b und f der beiden Schichten 9 und 10 ausserhalb des Halbleitermaterials elektrisch miteinander verbunden und mit je einer Kontaktdiffusion 13 bzw. 14 versehen sind, die an der Oberfläche in die zugehörige Schicht 9 bzw. 10 eindiffundiert sind.

In der in der Fig. 4 dargestellten erste Variante besteht die Photodiode 5 aus der Schicht 11, die an der Oberfläche in der Schicht 12 angeordnet ist, die sich ihrerseits an der Oberfläche im Substrat 7 befindet. Das Substrat 7 und die Schicht 11 bestehen aus Halbleitermaterial vom gleichen Leitfähigkeitstyp N bzw. N2, während die Schicht 12 aus Halbleitermaterial vom entgegengesetzten Leitfähigkeitstyp P2 besteht. Die Schichten 11 und 12 besitzen an ihrer Oberfläche je einen metallischen Anschlusskontakt d bzw. e, wobei derjenige e der Schicht 12 mit einer Kontaktdiffusion 17 versehen ist, die an der Oberfläche in der Schicht 12 angeordnet ist. Die Oberflächen mindestens der beiden Photodioden 4 und 5 sind mit einer ultraviolettlichtdurchlässigen ersten Filterschicht F1 bedeckt, die gleichzeitig die Funktion einer Passivationsschicht ausüben kann, so dass keine getrennte Passivationsschicht mehr erforderlich ist. Die Photodiode 5 ist oberhalb der ersten Filterschicht F1 noch mit einer ultraviolettlichtundurchlässigen zweiten Filterschicht F2 bedeckt. Die zweite Filterschicht F2 bedeckt dabei nur die Photodiode 5. Die beiden Filterschichten F1 und F2 besitzen ggf. Öffnungen zum Anschluss der Metallverbindungen an die zugehörigen metallischen Anschlusskontakte a, b, d, f und g.

In der in der Fig. 5 dargestellten zweiten Variante besteht die Photodiode 5 aus einer Doppelschicht 11a; 11b, die sich an der Oberfläche in der Schicht 12 befindet, die ihrerseits an der Oberfläche im Substrat 7 angeordnet ist, wobei die Doppelschicht 11a; 11b die Schicht 11a enthält, die mindestens teilweise an der Oberfläche in der Schicht 11b angeordnet ist. Das Substrat 7 und die Schicht 11b bestehen aus Halbleitermaterial vom gleichen Leitfähigkeitstyp N bzw. N1R und die Schichten 11a und 12 aus Halbleitermaterial vom gleichen jedoch entgegengesetzten Leitfähigkeitstyp P1R bzw. P2. Die Schicht 11a und/oder die Schicht 12 besitzen an ihrer Oberfläche einen gemeinsamen metallischen Anschlusskontakt e und die Schicht 11b weist an ihrer Oberfläche einen metallischen Anschlusskontakt d auf, wobei die beiden Anschlusskontakte e und d mit je einer Kontaktdiffusion 17 bzw. 18 versehen sind, die an der Oberfläche in der dem Anschlusskontakt e bzw. d zugehörigen Schicht 11a oder 12 bzw. 11b angeordnet ist. Die Schicht 11a kann sich an der Oberfläche ganz in der Schicht 11b befinden. In diesem Fall müssen die beiden Schichten 11a und 12 ausserhalb des Halbleitermaterials mit elektrischen Kurzschlussverbindungen verbunden sein. Eine andere Möglichkeit ist, wie in der Fig.5 dargestellt, dass die Schicht 11a an der Oberfläche sowohl in der Schicht 11b als auch in der Schicht 12 angeordnet ist. In diesem Fall sind die beiden Schichten 11a und 12 automatisch elektrisch miteinander verbunden. Da in allen Fällen die beiden Schichten 11a und 12 elektrisch miteinander verbunden sind, kann der Anschlusskontakt e mit seiner Kontaktdiffusion 17 an der Oberfläche sowohl der Schicht 11a als auch der Schicht 12 angeordnet sein. Die in der Fig. 5 dargestellte zweite Variante des integrierten Aufbaus der in der Fig. 3 dargestellten kompensierten Ultraviolettlicht-Photodiode ist somit ähnlich aufgebaut wie der in der Fig. 4 dargestellte Aufbau der ersten Variante mit dem hauptsächlichen Unterschied, dass die Schicht 11 ersetzt ist durch die Kombination 11a;11b der beiden Schichten 11a und 11b.

In beiden Varianten besitzt das Substrat 7 an der Oberfläche einen metallischen Anschlusskontakt g, der mit einer Kontaktdiffusion 15 versehen ist, die an der Oberfläche entweder direkt im Substrat 7 oder wie in der Fig. 5 dargestellt in einer weiteren Kontaktdiffusion 16 angeordnet ist, wobei beide Kontaktdiffusionen 15 und 16 aus Halbleitermaterial vom gleichen Leitfähigkeitstyp N2 bzw. N1 bestehen wie das Substrat 7 und wobei die weitere Kontaktdiffusion 16 sich an der Oberfläche im Substrat 7 befindet.

Die metallischen Anschlusskontakte a, b, d, e, f und g ggf. ergänzt durch die ihnen zugehörige Kontaktdiffusion bzw. Kontaktdiffusionen stellen jeweils einen ohmischen Anschlusskontakt dar. In der Fig. 4 und der Fig. 5 sind die Anschlusskontakte a und d einerseits sowie b, f, g und e anderseits mittels einer nicht dargestellten Metallisierung oder, wie in den Figuren 4 und 5 dargestellt, mittels ausserhalb des Halbleitermaterials gelegener Verbindungen elektrisch miteinander verbunden, um die in der Fig. 3 dargestellte elektrische Schaltung zu verwirklichen.

In den Figuren 4 und 5 wurde angenommen, dass sofern vorhanden die Schichten 8, 11 und 11a sowie die Kontaktdiffusionen 13 bis 15 und 17 bis 18 eine gleiche Diffusionstiefe d1, die Schichten 9 und 11b sowie die Kontaktdiffusion 16 eine gleiche Diffusionstiefe d2 und die Schichten 10 und 12 eine gleiche Diffusionstiefe d3 aufweisen.

Die Schicht 9 und die Kontaktdiffusion 16 besitzen eine annähernd gleiche Dotierung, was durch die Bezeichnung N1 angedeutet ist. Die Kontaktdiffusionen 13, 15 und sofern vorhanden 18 besitzen ebenfalls eine gleiche jedoch andere Dotierung, was durch die Bezeichnung N2 angedeutet ist. Die Schicht 11b, sofern vorhanden, besitzt ihrerseits einen noch andern Wert der Dotierung, was durch die Bezeichnung N1R angedeutet ist. Die Schicht 8 sowie die Kontaktdiffusionen 14 und 17 besitzen ebenfalls eine gleiche Dotierung, was durch die Bezeichnung P1 angedeutet ist, während die Schichten 10 und 12 eine gleiche jedoch andere Dotierung aufweisen, was durch die Bezeichnung P2 angedeutet ist. Die Schicht 11a, sofern vorhanden, besitzt einen weiteren Wert der Dotierung, was durch die Bezeichnung P1R angedeutet ist. Das Substrat 7 besitzt einen eigenen Wert der Dotierung, was durch die Bezeichnung N angedeutet ist.

Die Schichten 8, 9 und 10 aus P1-, N1- und P2-Material bilden die Photodiode 4. Die Schichten 11a, 11b und 12 aus P1R-, N1R-und P2-Material bzw. 11 und 12 aus N2- und P2-Material bilden in der Darstellung der Fig. 5 bzw. der Fig. 4 die Photodiode 5. Diese Schichten bestimmen jeweils die optischen und elektrischen Grundeigenschaften der betreffenden Photodiode 4 bzw. 5.

Eine Metallisierungsschicht und eine Passivationsschicht, die in der Regel auf der Oberfläche des Halbleitermaterials angeordnet sind, wurden in den Figuren 4 und 5 aus Gründen der zeichnerischen Einfachheit nicht dargestellt, es sei denn, dass die Passivationsschicht mit der ersten Filterschicht F1 identisch sei.

In der Fig. 6 sind die Verteilungen der Fremdatome im Halbleitermaterial in Gestalt von sieben Kennlinien 20 bis 26 als Dotierungsprofile, d. h. als Trägerkonzentrationen c in Funktion der Diffusionstiefen d dargestellt. Die Trägerkonzentrationen c werden z. B. in $cm^{-3}$ und die Diffusionstiefen d in $\mu m$ gemessen. Diese Dotierungsprofile werden mit Hilfe von Ionenimplantationen erzielt und besitzen annähernd die Gestalt von Gaussschen Kennlinien. Dabei entspricht die Kennlinie 20 der Dotierung N2, die Kennlinie 21 der Dotierung P1, die Kennlinie 22 der Dotierung P1R, die Kennlinie 23 der Dotierung N1R, die Kennlinie 24 der Dotierung N1, die Kennlinie 25 der Dotierung P2 und die Kennlinie 26 der Dotierung N. Die Kennlinien 20 bis 22 besitzen je ein Maximum an der Oberfläche des Halbleitermaterials, d. h. bei einem Wert d = 0. Die Maxima der Kennlinien 23 bis 25 liegen jeweils bei Werten von d gleich x2, x1 bzw. x3, während die Kennlinie 26 kein ausgeprägtes Maximum aufweist. Die Kennlinie 25 schneidet die Kennlinie 26 bei einem Wert d = d3 und die Kennlinien 23 und 24 bei einem Wert d = d2R bzw. d = d2, während die Kennlinie 22 die Kennlinie 23 in einem Wert d = d1R und die Kennlinie 21 die Kennlinie 24 in einem Wert d = d1 schneidet.

Typische Dotierungen sind:
- P1-Material : Bor, E = 10keV und Q = $6.10^{13} cm^{-2}$,
- P1R-Material: Bor, E = 10keV und Q = $1.10^{13} cm^{-2}$,
- P2-Material : Bor, E = 200keV und Q = $3.10^{13} cm^{-2}$,
- N1-Material : Phosphor, E = 100 keV und Q = $3.10^{13} cm^{-2}$,
- N1R-Material: Phosphor, E = 80 keV und Q = $3.10^{13} cm^{-2}$ und
- N2-Material : Phosphor, E = 32 keV und Q = $1.10^{15} cm^{-2}$.

Dabei bezeichnet E die Ionen-Energie und Q die Ionen-Dosis. Die Ionenimplantationen erfolgen durch eine Schicht SiO2, die annähernd eine Dicke von 30 nm aufweist und in der Zeichnung nicht dargestellt ist. Nach den Ionenimplantationen erfolgt jeweils ein schneller thermischer Temperverfahrensschritt ("annealing step") zur Aktivierung der Fremdatomen. Dieser Temperverfahrensschritt muss sehr schnell erfolgen, damit während seiner Dauer keine Verteilung der Fremdatomen erfolgen kann.

Die Schicht 9 der Photodiode 4 besitzt unmittelbar unterhalb der Oberfläche des Halbleitermaterials einen photoempfindlichen Bereich K (siehe Fig. 6), der von dieser Oberfläche bis zu einer Potentialbarriere M reicht (siehe Fig. 5), die in einer Tiefe d = x1 von annähernd $0,1\mu m$ im Halbleitermaterial der Schicht 9 liegt, nachfolgend als erste Potentialbarriere M bezeichnet wird und in der Fig. 5 innerhalb des Halbleitermaterials N1 der Schicht 9 gestrichelt dargestellt ist. Die Tiefe dieses photoempfindlichen Bereichs der Photodiode 4 ist annähernd gleich der Eindringtiefe des ultravioletten Lichtes in das verwendete Halbleitermaterial. Da die Eindringtiefe des sichtbaren Lichtes und des Infrarotlichtes in dieses Halbleitermaterial bedeutend grösser ist als die Tiefe des photoempfindlichen Bereichs der Photodiode 4, wird nur ein verschwindend kleiner Teil des nichtultravioletten Lichtes in diesem Bereich absorbiert, so dass die Photodiode 4 viel empfindlicher gegenüber dem ultravioletten Licht ist als gegenüber dem sichtbaren Licht und dem Infrarotlicht.

Die Photodiode 5 hat ihrerseits ebenfalls einen photoempfindlichen Bereich, der diesmal mit L bezeichnet ist (siehe Fig. 6) und der für die in der Fig. 5 dargestellten Variante zwischen einer zweiten Potentialbarriere R, die in einer Tiefe d = x2 im Halbleitermaterial N1R der Schicht 11b liegt, und einer dritten Potentialbarriere S, die in einer Tiefe d = x3 im Halbleitermaterial P2 der Schicht 12 liegt, angeordnet ist (siehe Fig. 5). Die zweite Potentialbarriere R kann jedoch auch an der Oberfläche des Halbleitermaterials liegen, was der in der Fig. 4 dargestellten Variante entspricht. Die Photodiode 5 weist somit innerhalb des ihr zugehörigen Teils des Halbleitermaterials immer mindestens die Potentialbarriere S auf. Die letzte ist immer tiefer im Halbleitermaterial angeordnet als die Potentialbarriere M der Photodiode 4, welche ihrerseits innerhalb des der Photodiode 4 zugehörigen Teils des Halbleitermaterials angeordnet ist.
Allgemein gilt: 0≦x2<x3.

In der Fig. 5 sind die beiden Potentialbarrieren R und S gestrichelt im Halbleitermaterial N1R der Schicht 11b bzw. P2 der Schicht 12 dargestellt.

Wenn x2>0, dann ist der photoempfindliche Bereich L der Photodiode 5 im Halbleitermaterial vergraben und das ultraviolette Licht wird fast vollständig absorbiert im Bereich des Halbleitermaterials, der zwischen der Oberfläche des Halbleitermaterials und der zweiten Potentialbarriere R liegt, während das sichtbare Licht und das Infrarotlicht im photoempfindlichen Bereich L der Photodiode 5 absorbiert wird. Die Photodiode 5 ist somit empfindlicher gegenüber sichtbarem Licht und Infrarotlicht als gegenüber ultraviolettem Licht. Der Fall x2>0 ist in der Fig. 5 dargestellt.

Wenn $x2 = 0$, dann ist die Photodiode 5 ebenfalls ultraviolettlichtempfindlich. In diesem Fall muss diese nicht gewünschte Ultraviolettlicht-Empfindlichkeit der Photodiode 5 mit Hilfe einer der beiden folgenden Methoden reduziert werden:

1) Die aktive Fläche $A_R$ der Photodiode 5, d. h. die Fläche der Draufsicht der zweiten Potentialbarriere R muss viel kleiner sein als die aktive Fläche $A_M$ der Photodiode 4, d. h. der Fläche der Draufsicht der ersten Potentialbarriere M.

2) Die Oberfläche der Photodiode 5 muss mit einer zusätzlichen optischen Filterschicht F2 bedeckt sein, welches ausschliesslich langwelliges Licht durchlässt (siehe Fig. 4). Als Filtermaterial kann einige mm dickes Fensterglas, welches für Licht mit Wellenlängen grösser als $0,35\mu m$ durchlässig ist, oder eine dünne Schicht eines bestimmten Halbleiters, wie z. B. ZnO oder ZnS, verwendet werden, die für Licht mit Wellenlängen grösser als $0,36\mu m$ bzw. $0,33\mu m$ durchlässig ist. Die Dicke der dünnen Schicht ist dann in der Grössenordnung eines $\mu m$.

Die Dicke $x3-x2$ des photoempfindlichen Bereichs L der Photodiode 5 muss viel kleiner sein sowohl als die Eindringtiefe des Infrarotlichtes als auch die Diffusionslänge der Ladungsträger, d. h. $x3-x2$ sollte z. B. kleiner als $1\mu m$ sein. In diesem Fall sind die Temperaturabhängigkeit und die Abhängigkeit von Prozessvariationen der Infrarotlicht-Empfindlichkeit der beiden Photodioden 4 und 5 annähernd gleich. Eine noch bessere Anpassung der gegenseitigen Infrarotlicht-Empfindlichkeit der beiden Photodioden 4 und 5 wird erzielt, wenn folgende Gleichung erfüllt ist:

$$T_4 . A_M . x1 = T_5 . A_R . (x3-x2) \qquad (I),$$

wobei $T_4$ und $T_5$ die Transmissionskoeffizienten des Infrarotlichtes und des sichtbaren Lichtes in der Schicht sind, die die Oberfläche der Photodiode 4 bzw. 5 bedeckt. Da $T_4$ und $T_5$ annähernd gleich sind, bedeutet dies, dass die photoempfindlichen Bereiche der beiden Photodioden 4 und 5 annähernd ein gleiches Volumen aufweisen müssen.

Für die oben angegebenen Ionen-Energien gelten folgende typische Werte:
$x1 \approx x2 = 0,1\mu m$ und
$x3 = 0,5\mu m$.

Mit diesen Werten ergibt die Gleichung (I): $A_M/A_R \approx 4$, wobei z. B. $A_M = 0,8mm^2$ und $A_R = 0,2mm^2$.

Da in der Praxis ein Interesse besteht, möglichst viele Schichten zu verwenden, die eine gleiche Diffusionstiefe aufweisen, werden die Kennlinien 21 bis 24 nach Möglichkeit so gewählt, dass annähernd $d1 = d1R$ und $d2 = d2R$, was in der Darstellung der Fig. 5 angenommen wurde.

In der in der Fig. 4 dargestellten Anordnung übernimmt die Halbleiterschicht 11 aus N2-Material die Rolle der Schicht 11b aus N1R-Material der in der Fig. 5 dargestellten Anordnung, während die Halbleiterschicht 11a aus P1R-Material nicht mehr vorhanden ist. Dies entspricht dem Fall $x2 = 0$.

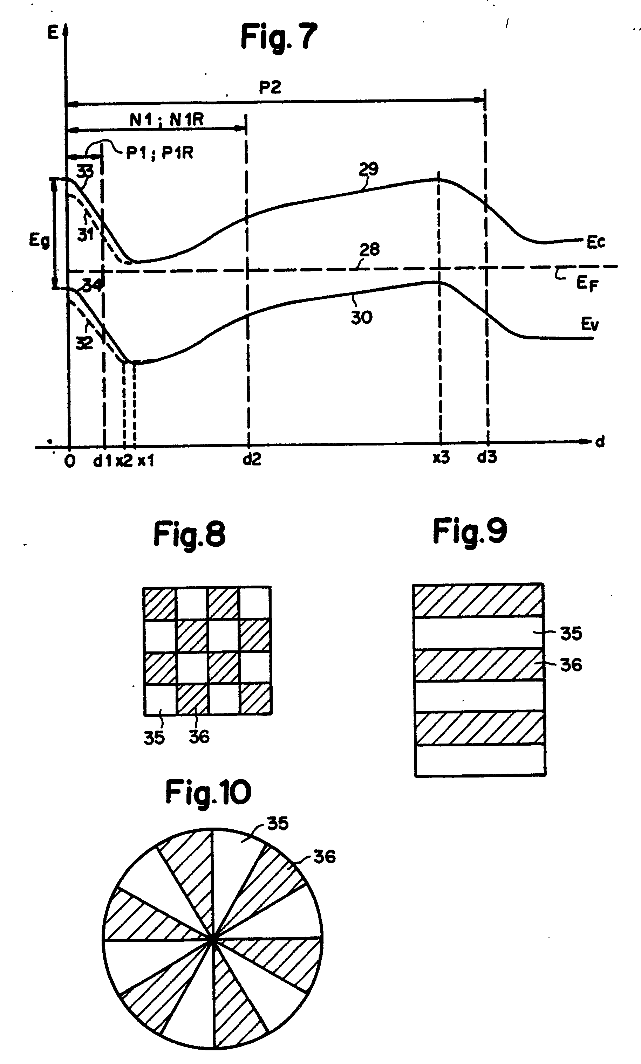

In der Fig. 7 sind die Energieverteilung innerhalb der verschiedenen Halbleiterschichten der in der Fig. 5 dargestellten Anordnung in Funktion der Diffusionstiefe d sowie die Lagen d1, d2 und d3 der Grenzschichten zwischen zwei benachbarten Schichten sowie die Lagen x1, x2 und x3 der verschiedenen Dotierungsmaxima dargestellt. Eine gestrichelte Linie 28 parallel zur Abszisse stellt das Fermi-Niveau $E_F$ dar, während die in der Zeichnung obere Kennlinie 29 die Leitungsbandgrenze $E_C$ und die untere Kennlinie 30 die Valenzbandgrenze $E_V$ darstellt. Der Abstand zwischen den beiden Kennlinien 29 und 30 parallel zur Ordinate gemessen ist die Bandlücke $E_g$. Die links in der Fig. 7 dargestellten gestrichelten Teile 31 und 32 der Kennlinien 29 und 30 entsprechen der Photodiode 5, während die vollausgezogenen Kennlinienteile 33 und 34 der Photodiode 4 zugehörig sind.

Die Potential-Minima in einer Tiefe $d = x1$ und $d = x2$ verhindern, dass die in den Oberflächenregionen $0 < d < x1$ und $0 < d < x2$ generierten Löcher in den Regionen $d > x1$ bzw. $d > x2$ der Photodioden 4 und 5 eindringen und üben somit die Funktion der ersten und zweiten Potentialbarriere M und R aus. Das Potential-Maximum bei $d = x3$ verhindert, dass im Substrat 7 generierte Elektronen im Bereich $d < x3$ eindringen können und übt somit die Funktion der dritten Potentialbarriere S aus.

Bei der Messung von nichtuniformem Licht bestehen die beiden Photodioden 4 und 5 vorzugsweise jeweils aus einer Vielzahl parallel geschalteter kleinerer Photodioden 35 bzw. 36, die wie in den Figuren 8 bis 10 dargestellt jeweils räumlich abwechselnd an der Oberfläche im Substrat 7 angeordnet sind. In der Fig. 8 sind die Draufsichten der kleineren Photodioden 35 und 36 quadratisch und die kleineren Photodioden 35 und 36 in der Draufsicht abwechselnd gleich angeordnet wie die weissen und schwarzen Felder eines Schachbrettes. In der Fig. 9 sind die Draufsichten der kleineren Photodioden 35 und 36 rechteckförmig und die kleineren Photodioden 35 und 36 in der Draufsicht streifenförmig abwechselnd übereinander oder, nicht dargestellt, nebeneinander angeordnet. In der Fig. 10 besitzt die kompensierte Ultraviolettlicht-Photodiode 4; 5 eine kreisförmige Draufsicht. In diesem Fall sind die Draufsichten der kleineren Photodioden 35 und 36 vorzugsweise kreissektorförmig und die kleineren Photodioden 35 und 36 in der Draufsicht abwechselnd in einem Kreis herum nebeneinander angeordnet.

Die beiden Photodioden 4 und 5 können auch in diskreten oder hybriden Varianten realisiert werden. In diesem Fall sind sie in zwei getrennten Halbleiterchips angeordnet und diese entweder in zwei getrennten Gehäusen oder auf ein gemeinsames Keramiksubstrat montiert. Jede der beiden Photodioden 4 und 5 ist dabei mittels getrennter Filter F1 und F2 oder mittels getrennter Linsen bedeckt, wobei diese Linsen die Rolle der Filter F1 und/oder F2 übernehmen. Z. B. kann die Photodiode 4 mit einer ultraviolettlichtdurchlässigen Linse bedeckt sein, während die Photodiode 5 mit einer Linse bedeckt ist, die nicht ultraviolettlichtdurchlässig ist.

Die kompensierte Ultraviolettlicht-Photodiode kann hergestellt werden mit Hilfe der bekannten in der integrierten Halbleitertechnik üblichen Verfahrensschritte, wie z. B. Photolithogragphie, Ionenimplantation, Dünnschichtablagerungen, usw.

## Ansprüche

1. Ultraviolettlicht-Photodiode (4; 5) bestehend aus der Kombination zweier Photodioden (4, 5), die elektrisch so miteinander verbunden sind, dass bei Belichtung der beiden Photodioden (4, 5) ein Signal entsteht, welches proportional der Differenz beider Diodenströme (I1, I2) ist, und wobei die Maxima der spektralen Empfindlichkeitskurven (1, 2) beider Photodioden (4, 5) unterschiedliche Wellenlängen aufweisen, dadurch gekennzeichnet, dass die spektralen Empfindlichkeitskurven (1, 2) beider Photodioden (4, 5) im Bereich der Wellenlängen des sichtbaren Lichtes und des Infrarotlichtes annähernd gleiche Werte besitzen, so dass in diesem Bereich sich die Diodenströme (I1, I2) beider Photodioden (4, 5) annähernd durch die Differenzbildung kompensieren, und dass eine erste der beiden Photodioden (4) im Bereich der Wellenlängen des ultravioletten Lichtes empfindlicher ist als die zweite Photodiode (5), so dass die Empfindlichkeitskurve (3) der Ultraviolettlicht-Photodiode (4; 5) schmalbandig im Bereich der Wellenlängen des ultravioletten Lichtes ein Maximum aufweist.

2. Ultraviolettlicht-Photodiode (4; 5) nach Anspruch 1, dadurch gekennzeichnet, dass die beiden Photodioden (4, 5) aus Halbleitermaterial bestehen und dass die zweite Photodiode (5) innerhalb des ihr zugehörigen Teils des Halbleitermaterials mindestens eine Potentialbarriere (S) aufweist, die tiefer im Halbleitermaterial angeordnet ist als eine Potentialbarriere (M) der ersten Photodiode (4), die innerhalb des der ersten Photodiode (4) zugehörigen Teils des Halbleitermaterials angeordnet ist.

3. Ultraviolettlicht-Photodiode (4; 5) nach Anspruch 1 oder 2, dadurch gekennzeichnet, dass die erste Photodiode (4) aus einer ersten Schicht (8) besteht, die an der Oberfläche in einer zweiten Schicht (9) angeordnet ist, die sich ihrerseits an der Oberfläche in einer dritten Schicht (10) befindet, welche wiederum an der Oberfläche in einem Substrat (7) angeordnet ist, dass einerseits die erste und dritte Schicht (8, 10) aus Halb leitermaterial vom gleichen Leitfähigkeitstyp (P1, P2) und anderseits die zweite Schicht (9) und das Substrat (7) aus Halbleitermaterial vom entgegengesetzten Leitfähigkeitstyp (N1, N) bestehen, und dass die drei Schichten (8, 9, 10) je einen Anschlusskontakt (a, b bzw. f) aufweisen, wobei diejenigen (b, f) der zweiten und dritten Schicht (9, 10) ausserhalb des Halbleitermaterials elektrisch miteinander verbunden sind und mit je einer Kontaktdiffusion (13 bzw. 14) versehen sind, die an der Oberfläche in die zugehörige Schicht (9 bzw. 10) eindiffundiert sind.

4. Ultraviolettlicht-Photodiode (4; 5) nach einem der Ansprüche 1 bis 3, dadurch gekennzeichnet, dass die zweite Photodiode (5) aus einer ersten Schicht (11) besteht, die an der Oberfläche in einer zweiten Schicht (12) angeordnet ist, die sich ihrerseits an der Oberfläche in einem Substrat (7) befindet, dass das Substrat (7) und die erste Schicht (11) aus Halbleitermaterial vom gleichen Leitfähigkeitstyp (N, N2) und die zweite Schicht (12) aus Halbleitermaterial vom entgegengesetzten Leitfähigkeitstyp (P2) bestehen, dass die beiden Schichten (11, 12) der zweiten Photodiode (5) an ihrer Oberfläche je einen Anschlusskontakt (d bzw. e) besitzen, wobei derjenige (e) der zweiten Schicht (12) mit einer Kontaktdiffusion (17) versehen ist, die an der Oberfläche in der zweiten Schicht (12) der zweiten Photodiode (5) angeordnet ist, und dass mindestens die Oberflächen der beiden Photodioden (4, 5) mit einer ultraviolettlichtdurchlässigen ersten Filterschicht (F1) sowie die zweite Photodiode (5) oberhalb der ersten Filterschicht (F1) noch mit einer ultraviolettlichtundurchlässigen zweiten Filterschicht (F2) bedeckt ist.

5. Ultraviolettlicht-Photodiode (4; 5) nach einem der Ansprüche 1 bis 3, dadurch gekennzeichnet, dass die zweite Photodiode (5) aus einer Doppelschicht (11a; 11b) besteht, die sich an der Oberfläche in einer zweiten Schicht (12) befindet, die ihrerseits an der Oberfläche in einem Substrat (7) angeordnet ist, wobei die Doppelschicht (11a; 11b) eine erste Schicht (11a) enthält, die mindestens teilweise an der Oberfläche in einer weiteren Schicht (11b) angeordnet ist, dass das Substrat (7) und die weitere Schicht (11b) aus Halbleitermaterial vom gleichen Leitfähigkeitstyp (N, N1R) und die erste und zweite Schicht (11a, 12) aus Halbleitermaterial vom entgegengesetzten Leitfähigkeitstyp (P1R, P2) bestehen, und dass die erste Schicht (11a) und/oder die zweite Schicht (12) an ihrer Oberfläche einen gemeinsamen Anschlusskontakt (e) besitzen sowie die weitere Schicht (11b) einen Anschlusskontakt (d) aufweist, wobei die beiden Anschlusskontakte (e, d) mit je einer Kontaktdiffusion (17, 18) versehen sind, die an der Oberfläche in der dem Anschlusskontakt (e bzw. d) zugehörigen Schicht (11a oder 12 bzw. 11b) angeordnet ist.

6. Ultraviolettlicht-Photodiode (4; 5) nach einem der Ansprüche 3 bis 5, dadurch gekennzeichnet, dass die beiden Photodioden (4, 5) das gleiche Substrat (7) besitzen und dass das Substrat (7) an der Oberfläche einen Anschlusskontakt (g) besitzt, der mit einer Kontaktdiffusion (15) versehen ist, die an der Oberfläche entweder im Substrat (7) oder in einer weiteren Kontaktdiffusion (16) angeordnet ist, wobei beide Kontaktdiffusionen (15, 16) aus Halbleitermaterial vom gleichen Leitfähigkeitstyp (N2, N1) bestehen wie das Substrat (7) und die weitere Kontaktdiffusion (16) sich an der Oberfläche im Substrat (7) befindet.

7. Ultraviolettlicht-Photodiode (4; 5) nach einem der Ansprüche 3 bis 5, dadurch gekennzeichnet, dass die beiden Photodioden (4, 5) mit getrennten Substraten aufgebaut sind und ausserhalb des jeweiligen Halbleitermaterials elektrisch miteinander verbunden sind.

8. Ultraviolettlicht-Photodiode (4; 5) nach einem der Ansprüche 1 bis 6, dadurch gekennzeichnet, dass die beiden Photodioden (4, 5) jeweils aus einer Vielzahl parallel geschalteter kleinerer Photodioden (35 bzw. 36) bestehen, die jeweils räumlich abwechselnd an der Oberfläche im Substrat (7) angeordnet sind.

9. Ultraviolettlicht-Photodiode (4; 5) nach Anspruch 8, dadurch gekennzeichnet, dass die Draufsichten der kleineren Photodioden (35, 36) quadratisch sind und die kleineren Photodioden (35, 36) in der Draufsicht abwechselnd gleich angeordnet sind wie die weissen und schwarzen Felder eines Schachbrettes.

10. Ultraviolettlicht-Photodiode (4; 5) nach Anspruch 8, dadurch gekennzeichnet, dass die Draufsichten der kleineren Photodioden (35, 36) rechteckförmig sind und die kleineren Photodioden (35, 36) in der Draufsicht streifenförmig abwechselnd übereinander oder nebeneinander angeordnet sind.

11. Ultraviolettlicht-Photodiode (4; 5) nach Anspruch 8, dadurch gekennzeichnet, dass die Draufsichten der kleineren Photodioden (35, 36) kreissektorförmig sind und die kleineren Photodioden (35, 36) in der Draufsicht abwechselnd in einem Kreis herum nebeneinander angeordnet sind.

12. Ultraviolettlicht-Photodiode (4; 5) nach einem der Ansprüche 1 bis 11, dadurch gekennzeichnet, dass die beiden Photodioden (4, 5) in Gegenrichtung elektrisch in Reihe geschaltet sind und so eine Reihenschaltung bilden, deren Anschlusskontakte (a, e) mit je einem von zwei Eingängen eines Differenzverstärkers (6) verbunden sind.

13. Ultraviolettlicht-Photodiode (4; 5) nach einem der Ansprüche 1 bis 11, dadurch gekennzeichnet, dass die beiden Photodioden (4, 5) in Gegenrichtung elektrisch parallel geschaltet sind und bei Belichtung einen Differenzstrom (I1-I2) erzeugen.

# Fig. 1

# Fig.2

# Fig. 3

# Fig.4

# Fig. 5

# Fig. 6

Fig. 7

Fig. 8

Fig. 9

Fig. 10

Europäisches
Patentamt

**EUROPÄISCHER RECHERCHENBERICHT**

Nummer der Anmeldung

EP 90 10 0289

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 3, Nr. 136 (E-151), 13. November 1979, Seite 139 E 151; & JP-A-54 115 286 (SHARP K.K.) 07-09-1979 * Die ganze Zusammenfassung * --- | 1,7,12 | H 01 L  31/101 H 01 L  31/103 H 01 L  31/11 |
| A | PATENT ABSTRACTS OF JAPAN, Band 7, Nr. 136 (E-181)[1281], 14. Juni 1983; & JP-A-58 50 783 (MITSUBISHI DENKI K.K.) 25-03-1983 * Die ganze Zusammenfassung * --- | 1,2,6, 12 | |
| A | US-A-4 749 851  (R.F. WOLFFENBUTTEL) * Spalte 9, Zeile 46 - Spalte 13, Zeile 5; Patentansprüche; Figuren 11-15 * --- | 1,2,6,8 | |
| A | US-A-4 318 115  (T. YOSHIKAWA et al.) * Das ganze Dokument * --- | 1-4,6, 12 | |
| A | PATENT ABSTRACTS OF JAPAN, Band 8, Nr. 111 (E-246)[1548], 24. Mai 1984, page 137 E 246; & JP-A-59 27 581 (SEISAN GIJUTSU SHINKOU KIYOUKAI) 14-02-1984 * Die ganze Zusammenfassung * --- | 1 | **RECHERCHIERTE SACHGEBIETE (Int. Cl.5)** H 01 L |
| D,A | EP-A-0 296 371  (LGZ LANDIS & GYR ZUG AG) * Spalte 8, Zeile 53 - Spalte 12, Zeile 56; Figuren 9-11 * --- | 1-3 | |
| A | US-A-4 011 016  (C.R. LAYNE et al.) ----- | | |

Der vorliegende Recherchenbericht wurde für alle Patentansprüche erstellt

| Recherchenort | Abschlußdatum der Recherche | Prüfer |
|---|---|---|
| DEN HAAG | 15-05-1990 | VISENTIN A. |

EPO FORM 1503 03.82 (P0403)